# EUROPEAN PATENT APPLICATION

(11) **EP 4 033 503 A1**
(43) Date of publication of application: **27.07.2022**
(21) Application number: 21153254.4
(22) Date of filing: 25.01.2021
(51) Int. Cl.: H01F 10/32, H01F 41/30, H01L 39/22

(54) **A METHOD FOR FABRICATING A MAGNETIC SPIN VALVE DEVICE COMPRISING FERROMAGNETIC LAYERS WITH NON-COLLINEAR MAGNETIZATIONS**

(71) Applicant: Max-Planck-Gesellschaft zur Förderung der Wissenschaften e.V., 80539 München (DE)
(72) Inventor: KHAYDUKOV, Yury, 85376 Massenhausen (DE); KELLER, Thomas, 87459 Pfronten (DE); KEIMER, Bernhard, 70569 Stuttgart (DE); MORARI, Roman, MD-2000 Chisinau (MD); SIDORENKO, Anatolie, 2000 Chisinau (MD)
(74) Representative: Lambsdorff & Lange Patentanwälte Partnerschaft mbB

(57) **Abstract**

A method (100) for fabricating a magnetic device comprises providing a layer stack (110), the layer stack comprising a substrate,
a first ferromagnetic layer disposed above the substrate, the first ferromagnetic layer comprising a uniaxial magnetic anisotropy including an easy axis,
a non-magnetic layer disposed on the first ferromagnetic layer,
a second ferromagnetic layer disposed on the non-magnetic layer, the second ferromagnetic layer comprising a unidirectional anisotropy, and
an antiferromagnetic layer disposed on the second ferromagnetic layer, the antiferromagnetic layer comprising a Neel temperature T_{N};
heating the layer stack above the Neel temperature T_{N} of the antiferromagnetic layer (120);
applying a magnetic field H_{CL} to the layer stack, the magnetic field H_{CL} comprising a magnetic field direction having an arbitrary angle with respect to the easy axis (130);
cooling the layer stack below the Neel temperature T_{N} of the antiferromagnetic layer with the magnetic field H_{CL} applied; removing the magnetic field H_{CL}.

## Description

### TECHNICAL FIELD

The present disclosure is related in general to the technical field of magnetic spin valve devices and in particular to a method for fabricating a magnetic device, a magnetic device in a state before carrying out the method, and a magnetic device in a state after carrying out the method.

### BACKGROUND

The spin valve (SV) is an essential building block of many spintronic devices. A typical SV consists of two ferromagnetic (FM) layers separated by a non-magnetic layer N. The typical thickness of the F and N layers in a SV is in the order of 1-10nm. The electrical resistance of a SV strongly depends on the mutual alignment of the magnetization vectors M1 and M2 of F1 and F2 layers: for antiparallel (AP) alignment, the resistance of the structure exhibits a maximum value, while for parallel (P) alignment the resistance is minimum. Thus, the SV is analog to a transistor in conventional resistive electronics. In order to enable switching between AP and P states, the magnetization M2 is pinned by a strong exchange bias (EB) field to an antiferromagnet, while M1 has a small magnetic anisotropy and can be switched without affecting M2.

A classical SV requires switching between two collinear AP and P states, i.e. it is a digital devices so that the scope of possible applications is rather limited. For these and other reasons there is a need for the presence disclosure.

### SUMMARY

A first aspect of the present disclosure is related to a method for fabricating a magnetic device, the method comprising providing a layer stack, the layer stack comprising a substrate, a first ferromagnetic layer disposed above the substrate, the first ferromagnetic layer comprising a uniaxial magnetic anisotropy including an easy axis, a non-magnetic layer disposed on the first ferromagnetic layer, a second ferromagnetic layer disposed on the non-magnetic layer, the second ferromagnetic layer comprising a unidirectional anisotropy, and an antiferromagnetic layer disposed on the second ferromagnetic layer, the antiferromagnetic layer comprising a Neel temperature T_{N};
heating the layer stack above the Neel temperature T_{N} of the antiferromagnetic layer;
applying a magnetic field H_{CL} to the layer stack, the magnetic field H_{CL} comprising a magnetic field direction having an arbitrary angle with respect to the easy axis;
cooling the layer stack below the Neel temperature T_{N} of the antiferromagnetic layer with the magnetic field H_{CL} applied; and
removing the magnetic field H_{CL}.

A second aspect of the present disclosure is related to a magnetic device, the magnetic device comprising providing a layer stack, the layer stack comprising a substrate, a first ferromagnetic layer disposed above the substrate, the first ferromagnetic layer comprising a uniaxial magnetic anisotropy including an easy axis, a non-magnetic layer disposed on the first ferromagnetic layer, a second ferromagnetic layer disposed on the non-magnetic layer, the second ferromagnetic layer comprising a unidirectional anisotropy, and an antiferromagnetic layer disposed on the second ferromagnetic layer.

A third aspect of the present disclosure is related to a magnetic device, comprising a layer stack comprising a substrate, a first ferromagnetic layer disposed on the substrate, the first ferromagnetic layer comprising a first magnetization direction, a non-magnetic layer disposed on the first ferromagnetic layer, a second ferromagnetic layer disposed on the non-magnetic layer, the second ferromagnetic layer comprising a second magnetization direction, and an antiferromagnetic layer disposed on the second ferromagnetic layer; wherein the first and second magnetization directions are non-collinear including an arbitrary angle between them.

A forth aspect of the present disclosure is related to a use of a magnetic device according to the third aspect in one or more of an electronic device, an electronic switching device, a spin valve device, a triplet spin valve device, a multiple state electronic device, a multiple state resistor, a multiple state memory cell, a synapse in an artificial neuron network, a superconducting spintronic device, a Josephson junction, or a triplet Josephson junction.

The possibility to fix the magnetic configuration in an intermediate non-collinear (NC) state with an arbitrary angle between M1 and M2 will significantly expand the capabilities of the SV. Such a multiple state resistor can be used, for example, as a multi-state memory cell, or a synapse in artificial neuron networks. In addition, heterostructures consisting of NC ferromagnets and superconductors are promising systems in superconducting spintronics. Thus, the technical problem this proposal aims to solve is the creation of a non-volatile magnetic state with a controlled level of non-collinearity, this means with a well-defined angle.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 comprises Fig. 1A and 1B and shows a perspective view of the magnetic device in its initial state before carrying out the method (A) and a perspective view of the magnetic device in its final state after carrying out the method (B).
Fig. 2 shows a flow diagram of the method for fabricating a magnetic device.
Fig. 3 comprises Fig. 3A and 3B and shows hysteresis loops measured on the sample s6 at room temperature (A) and at T = 13 K after cooling of the sample in H_{CL} = - 4.5 kOe (B). The insert in Fig. 3B shows the hysteresis loop in the range of fields ± 5 kOe.
Fig. 4 comprises Fig. 4A and 4B and shows PNR data measures at 13K with external field H = 100 OE (A) and H = 10 Oe (B). Left insets show the magnetic configuration at the corresponding magnetic field obtained from numerical analysis of the PNR data, The right inset in Fig. 4B shows the H-dependence of waveguide enhanced spin-flip scattering (full circles) and NC angle Δα (open circles).

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

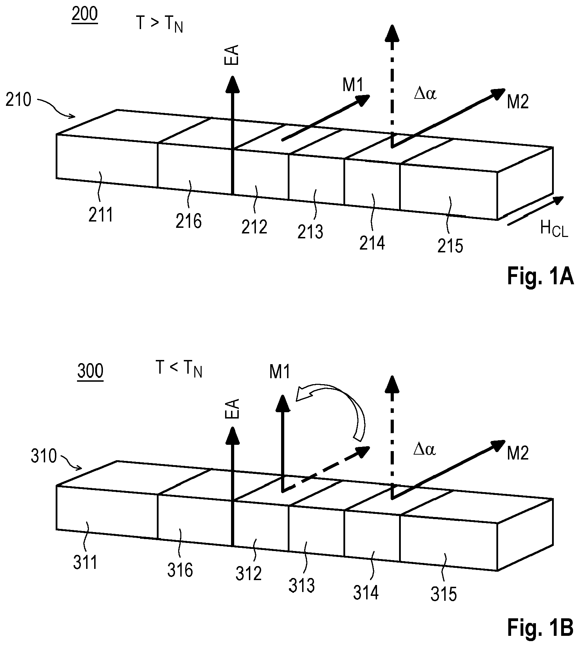

Fig. 1 comprises Fig. 1A and 1B and shows a perspective view of the magnetic device in its initial state before carrying out the method (A) and a perspective view of the magnetic device in its final state after carrying out the method (B).

The magnetic device 200 as shown in Fig. 1A comprises a layer stack 210 comprising a substrate 211, a first ferromagnetic layer 212 disposed above the substrate 211, the first ferromagnetic layer 212 comprising a uniaxial magnetic anisotropy including an easy axis, a non-magnetic layer 213 disposed on the first ferromagnetic layer 212, a second ferromagnetic layer 214 disposed on the non-magnetic layer 213, the second ferromagnetic layer 214 comprising a unidirectional anisotropy, and an antiferromagnetic layer 215 disposed on the second ferromagnetic layer 214.

The first and second ferromagnetic layers 212 and 214 comprise different types of magnetic anisotropy (uniaxial and unidirectional), and a non-magnetic spacer layer 213 disposed between them. The first ferromagnetic layer 212 is deposited on the substrate 211 with an optional non-magnetic buffer layer 216 disposed them. The first ferromagnetic layer 12 has an easy magnetic axis due to uniaxial magnetic anisotropy, which can be induced by the choice of substrate, the growth conditions, or by the shape anisotropy of the device. The second ferromagnetic layer 214 forms an exchange bias pair with the antiferromagnetic layer 215. The Neel temperature T_{N} of the antiferromagnetic layer 215 is chosen to be lower than the Curie temperature T_{M} of the second ferromagnetic layer 214. The exchange bias effect occurs between the neighboring antiferromagnetic layer 215 and the second ferromagnetic layer 214 at a temperature T with T < T_{N}. It induces a unidirectional anisotropy (UD) in the second ferromagnetic layer 214, such that the direction of the magnetization M2 can only be altered by a strong field larger than the exchange bias field H_{EB}. The latter is in the order of tens of Oe to several kOe, depending on the layer materials.

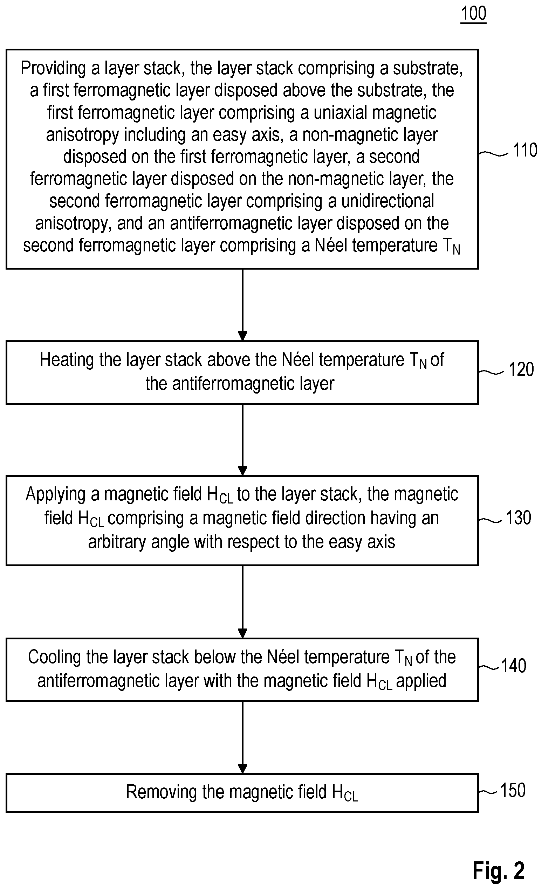

Fig. 2 shows a flow diagram of the method for fabricating a magnetic device.

The method 100 according to Fig. 2 comprises providing a layer stack such as that shown in Fig. 1A (110), heating the layer stack above the Neel temperature T_{N} of the antiferromagnetic layer (120), applying a magnetic field H_{CL} to the layer stack, the magnetic field H_{CL} comprising a magnetic field direction having an arbitrary angle with respect to the easy axis (130), cooling the layer stack below the Néel temperature T_{N} of the antiferromagnetic layer 15 with the magnetic field H_{CL} applied (140), and finally removing the magnetic field H_{CL} (150) .

As a result of method 100, a magnetic device such as that shown in Fig. 1B is obtained.

The magnetic device 300 shown in Fig. 1B comprises a layer stack 310 comprising a substrate 311, a first ferromagnetic layer 312 disposed on the substrate 311, the first ferromagnetic layer 312 comprising a first magnetization direction, a non-magnetic layer 313 disposed on the first ferromagnetic layer 312, a second ferromagnetic layer 314 disposed on the non-magnetic layer 313, the second ferromagnetic layer 314 comprising a second magnetization direction, and an antiferromagnetic layer 315 disposed on the second ferromagnetic layer 24, wherein the first and second magnetization directions are non-collinear including an arbitrary angle Δα.

At T > T_{N} the exchange bias between the second ferromagnetic layer 314 and the antiferromagnetic layer 315 and the unidirectional anisotropy of the second ferromagnetic layer 314 disappear, such that M2 can align parallel to a relatively small magnetic field H_{CL}. The direction of the unidirectional axis is defined by the magnetization vector M2 during cooling below T_{N}, which in turn is defined by the field H_{CL} applied during cooling.

Somewhat more specifically, defining or writing the non-collinear magnetization state with angle Δα requires the following steps:
(i) The antiferromagnetic layer 315 is heated above T_{N} to remove the exchange bias between the second ferromagnetic layer 314 and the antiferromagnetic layer 315.
(ii) A relatively small magnetic field H_{CL} is applied at an angle Δα with respect to the easy axis EA of the first ferromagnetic layer 312.
(iii) The system is cooled below T_{N} with the magnetic field H_{CL} applied. The magnetization direction of the second ferromagnetic layer 314 will stay parallel to H_{CL} during cooling, and the direction of the unidirectional anisotropy will be defined by M2.
(iv) Finally the magnetic field H_{CL} is removed. M2 is now stabilized by the exchange bias, and stays in the direction previously defined by H_{CL}- In this latter step after removing H_{CL}, M1 in the first ferromagnetic layer 312 aligns along the easy axis EA, such that in this remanent state (T < T_{N}, H = 0) the angle between M1 and M2 corresponds to the requested angle Δα. The angle Δα affects the electrical resistance of the layer system, such that the readout of the state is performed by measuring the resistance of the device, either in current-in-plane or current-perpendicular-to-plane mode.

Referring again to Fig. 1A, the first ferromagnetic layer 212 deposited on the substrate 211 with an optional buffer layer 216 has uniaxial anisotropy with the direction of the easy axis shown by the black arrow with caption EA. The second ferromagnetic layer 214 and the antiferromagnetic layer 215 form an exchange bias pair. According to Fig. 1A, above the Neel temperature T_{N} of the antiferromagnetic layer 215 an external magnetic field H_{CL} is applied at an angle Δα with respect to EA. The system then is cooled below T_{N} in the magnetic field H_{CL}. After release of the magnetic field H_{CL} to zero, the magnetization vector M1 of the first ferromagnetic layer 212 will turn towards the direction of EA while the magnetization M2 of the second ferromagnetic layer 214 will stay along the direction of H_{CL}, due to the exchange bias. The first and second ferromagnetic layers 212 and 214 of Fig. 1A will become the first and second ferromagnetic layers 312 and 314 of Fig. 1B. Thus according to Fig. 1B the remanent state will be characterized by the non-collinear alignment of M1 and M2 with the angle Δα.

In summary, the above-mentioned procedure allows to create a non-volatile device with a well-defined degree of non-collinearity.

The advantage of this method is that the non-collinear angle Δα between M1 and M2 can be set at arbitrary values between -90° and 90° (measured either from M1 to M2 or vice versa) in a reproducible and accurate way. The angle Δα is changed by, for example, heating above T_{N}, followed by cooling in the field with the required orientation. Another advantage of the method is a wide range of materials for the first and second ferromagnetic layers and the antiferromagnetic layer, which allows the system to be used in various applications. By choosing an antiferromagnetic layer with proper T_{N}, the operation temperature of the device is adapted to specific applications. For example, by choosing IrMn₃ with T_{N} > 300K as antiferromagnetic layer allows for preparation of devices working at room temperature. By choosing superconductors for the first and/or second non-magnetic layers, superconducting non-collinear spin valves or triplet Josephson junctions with variable and arbitrary Δα can be designed.

According to an embodiment of the magnetic devices and the method of the first to forth aspects, the antiferromagnetic layer comprises a Neel temperature T_{N} which is less than a Curie temperature T_{M} of the first ferromagnetic layer and the second ferromagnetic layer. According to a further embodiment the antiferromagnetic layer like IrMn₃ as mentioned above comprises a Neel temperature T_{N} which is greater than 300 K. However, it should be mentioned here that it is also possible to use an antiferromagnetic layer comprising a Neel temperature T_{N} below 300 K.

To test the feasibility of the proposed approach we produced a series of samples of nominal composition Nb(X)/Co(1.5nm)/Nb(X)/Co(2nm)/CoO(20nm). The samples were deposited on Al₂O₃ (1102) substrate by magnetron sputtering. This R-plane sapphire substrate is characterized by the presence of an anisotropic surface profile, which induces uniaxial anisotropy in the subsequent magnetic layers, even through relatively thick buffer layers. It has been previously shown that uniaxial anisotropy was induced by the sapphire substrate in a magnetic Ni layer through a 100nm thick V₂0₃ buffer. For the prototype system discussed here, niobium was used as buffer layer (layer 216 or 316) and spacer layer (layer 213 or 313), both with the same thickness X. For the different samples, X was varied between 6 nm and 14 nm, where in the following text X is also used to label the samples as sX. Niobium is a non-magnetic metal and a superconductor for X>6nm. Cobalt was chosen for the first and second ferromagnetic layers 12 and 14 as a strong ferromagnet with bulk Tₘ = 1400K. As the antiferromagnetic layer CoO(20nm) with T_{N=}290K was deposited on top of the structure. Our prior experiment has shown a strong exchange bias field H_{eb} ∼ -1.3kOe for the single bilayer Co(2nm)/CoO(20nm).

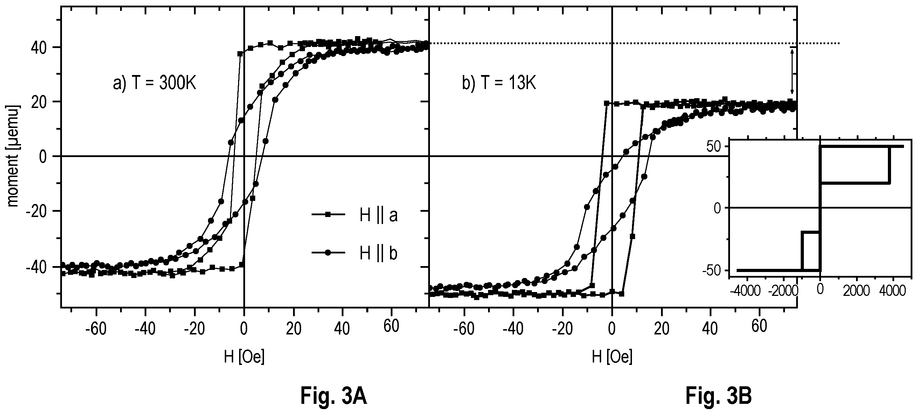

Fig. 3 shows the magnetic hysteresis loops measured on sample s6 (X=6nm) at room temperature (A) and at T=13K (B). In this experiment the magnetic field H was applied parallel to the surface along one of the edges of the square shaped substrates, denoted as a and b. Measurements at 13K were performed after cooling of the sample in a magnetic field of H_{CL} = -4.5kOe. The hysteresis loop in Fig. 3a shows that both FM layers are saturated for H > Hₛₐₜ = 50 Oe. The hysteresis loop for H| | a is almost rectangular while the hysteresis for H | | b is S-shaped with strongly suppressed remanent moment. This observation evidences the presence of UA, with the easy axis close to a. We indeed expect from the known substrate surface structure, that the easy axis is offset from direction a by the angle of 20°, which explains the small drop of the remanent magnetization in the H | | a loop. After cooling the sample to T=13K the hysteresis loop shifts downwards along the vertical axis by a value Δm = -15µemu. The shift originates from the moment of the second ferromagnetic layer which is pinned to the antiferromagnetic layer and ±75Oe field is not enough to change the direction of M2. Our previous experiment shows that a strong field in the order of 4kOe is required to switch the direction of M2 (see inset in Fig. 3b).

For the quantitative characterization of the non-collinearity Δα we performed polarized neutron reflectometry (PNR) experiments. We measured two non-spin-flip (NSF) reflectivity channels R⁺⁺ and R⁻⁻ and two spin-flip (SF) channels R⁺⁻ and R⁻⁺. Here the first (second) superscript sign denotes the spin direction of the incident (reflected) neutron spins. The presence of an asymmetry of the NSF curves S ≡ (R⁺⁺ - R⁻⁻)/(R⁺⁺ + R⁻⁻) evidences a magnetization structure with Ml, M2 collinear to external field magnetization, while non-zero SF scattering indicates the presence of non-collinear magnetization in the system. An analysis of all scattering channels provides quantitative information both about the magnetic depth profile of the in-plane magnetization vector.

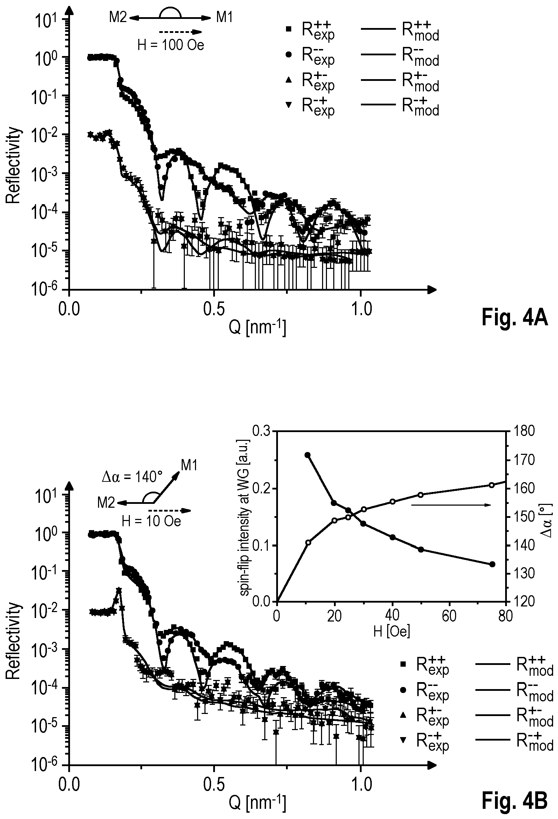

Fig. 4A shows all four reflectivity channels measured at T=13K in a magnetic field H=100 Oe | | b, after cooling the samples in the field H_{CL} = -4.5kOe. The latter also oriented | | b. Strong splitting of the NSF curves is observed, but no SF scattering apart from the background intensity caused by the 99% efficiency of spin-analyzer (this means that 1% of the NSF intensity leaks to the SF channels). Such a scattering pattern evidences pure collinear magnetic alignment. A numerical analysis of the PNR data shows that M1 and M2 are aligned antiparallel and collinear to the external field (see inset in Fig. 4A), so that at H=100 Oe the angle Δα=180°. This quantitative analysis is also in agreement with the hysteresis curve in Fig. 3B, where for M1 a small coercivity << 100 Oe is observed, while the bias on the M2 hysteresis is ∼ 1.3kG, such that at H=100 Oe M1 follows the field direction, but M2 is not affected and stays as defined during the cooling.

Reducing the field to H=10 Oe (Fig. 4B) leads to a spin-flip signal with a strong peak close to the critical edge of total reflection, a so-called waveguide enhanced SF scattering. The inset in Fig. 4B shows the field evolution of the SF intensity of this waveguide peak. Numerical analysis of these data shows a rotation of the magnetization M1 by α₁ = 40±5° towards its easy axis, while M2 again remains in the direction defined during cooling. Thus M1 and M2 are now in a NC alignment with Δα = 140° (inset Fig. 4B). By using the relation I^{SF} ∼ (sin α₁)² we can reconstruct the Δα(H) behavior, shown in the inset of Fig. 4B. By extrapolating this line to H=0 we can estimate remanent value Δα = 120°, which agrees within the experimental accuracy with SQUID data.

In summary, the experiment proves the existence of a non-collinear state in the prototype sample, which is easy to control by choosing the direction of the magnetic field H_{CL} applied during cooling. We point out that magnetizing field H_{CL} has to be larger than the anisotropy of the second ferromagnetic layer. The latter can be close to zero by proper design of the sputtering process. Thus, the orientation of the second ferromagnetic layer can be achieved by a weak field. We also observed that the NC magnetic state and thus the anisotropy of the first ferromagnetic layer persisted for all samples up to the thickest first ferromagnetic layer (X=14nm). Moreover, samples with X>10nm showed presence of superconductivity with transition temperature above 3K. Thus the layer scheme used for the present test experiment also enables the design of superconducting non-collinear spin valves. The robustness of the system is given by the exchange bias field of the second ferromagnetic/antiferromagnetic bilayer (>1kOe) and the anisotropy field of the first ferromagnetic layer (approximately 50 Oe for the prototype). The latter value can also be tuned by the sputtering process and/or layer design.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method (100) for fabricating a magnetic device, the method comprising
providing a layer stack (110), the layer stack comprising
a substrate,
a first ferromagnetic layer disposed above the substrate, the first ferromagnetic layer comprising a uniaxial magnetic anisotropy including an easy axis,
a non-magnetic layer disposed on the first ferromagnetic layer,
a second ferromagnetic layer disposed on the non-magnetic layer, the second ferromagnetic layer comprising a unidirectional anisotropy, and
an antiferromagnetic layer disposed on the second ferromagnetic layer, the antiferromagnetic layer comprising a Neel temperature T_{N};
heating the layer stack above the Neel temperature T_{N} of the antiferromagnetic layer (120);
applying a magnetic field H_{CL} to the layer stack, the magnetic field H_{CL} comprising a magnetic field direction having an arbitrary angle with respect to the easy axis (130);
cooling the layer stack below the Neel temperature T_{N} of the antiferromagnetic layer with the magnetic field H_{CL} applied (140); and
removing the magnetic field H_{CL} (150).

2. The method according to claim 1, wherein
the antiferromagnetic layer (16) comprises a Neel temperature T_{N} which is less than a Curie temperature T_{M} of the second ferromagnetic layer (14).

3. The method according to claim 1 or 2, wherein
the antiferromagnetic layer (16) comprises a Neel temperature T_{N} which is greater than 300 K.

4. The method according to any one of the preceding claims, further comprising
providing the layer stack (10) with a non-magnetic buffer layer (16) between the substrate (11) and the first ferromagnetic layer (12).

5. A magnetic device (200) comprising
a layer stack (210) comprising
a substrate (211),
a first ferromagnetic layer (212) disposed above the substrate (211), the first ferromagnetic layer (212) comprising a uniaxial magnetic anisotropy including an easy axis,
a non-magnetic layer (213) disposed on the first ferromagnetic layer (212),
a second ferromagnetic layer (214) disposed on the non-magnetic layer (213), the second ferromagnetic layer (214) comprising a unidirectional anisotropy, and
an antiferromagnetic layer (215) disposed on the second ferromagnetic layer (214).

6. The magnetic device (200) according to claim 5, wherein the antiferromagnetic layer (215) comprises a Neel temperature T_{N} which is less than a Curie temperature T_{M} of the second ferromagnetic layer (214).

7. The magnetic device (200) according to claim 5 or 6, wherein
the antiferromagnetic layer (215) comprises a Neel temperature T_{N} which is greater than 300 K.

8. The magnetic device (200) according to any one of claims 5 to 7, further comprising
a non-magnetic buffer layer (216) disposed between the substrate (211) and the first ferromagnetic layer (212).

9. The magnetic device (200) according to any one of claims 5 to 7 or 8, wherein
one or both of the non-magnetic layer (213) and the non-magnetic buffer layer (216) comprises a superconducting material.

10. A magnetic device (300), comprising
a layer stack (310) comprising
a substrate (311),
a first ferromagnetic layer (312) disposed on the substrate (311), the first ferromagnetic layer (312) comprising a first magnetization direction,
a non-magnetic layer (313) disposed on the first ferromagnetic layer (312),
a second ferromagnetic layer (314) disposed on the non-magnetic layer (313), the second ferromagnetic layer (314) comprising a second magnetization direction, and
an antiferromagnetic layer (315) disposed on the second ferromagnetic layer (314); wherein
the first and second magnetization directions are non-collinear including an arbitrary angle between them.

11. The magnetic device (300) according to claim 10, wherein the first ferromagnetic layer (312) comprises a uniaxial magnetic anisotropy; and
the second ferromagnetic layer (314) comprises a unidirectional anisotropy.

12. The magnetic device (300) according to claim 10 or 11, wherein
the antiferromagnetic layer (315) comprises a Neel temperature T_{N} which is less than a Curie temperature T_{M} of the second ferromagnetic layer (314).

13. The magnetic device (300) according to any one of claims 10 to 12, wherein
the antiferromagnetic layer (315) comprises a Neel temperature T_{N} which is greater than 300 K.

14. The magnetic device (300) according to any one of claims 10 to 13, further comprising
a non-magnetic buffer layer (316) disposed between the substrate (311) and the first ferromagnetic layer (312).

15. The magnetic device (200) according to any one of claims 10 to 13 or 14, wherein
one or both of the non-magnetic layer (313) and the non-magnetic buffer layer (316) comprises a superconducting material.

16. Use of a magnetic device according to any one of claims 10 to 15 in one or more of
- an electronic device,
- an electronic switching device,
- a spin valve device,
- a triplet spin valve device,
- a multiple state electronic device,
- a multiple state resistor,
- a multiple state memory cell,
- a synapse in an artificial neuron network,
- a superconducting spintronic device,
- a Josephson junction, or
- a triplet Josephson junction.
